# EUROPÄISCHE PATENTSCHRIFT

(11) **EP 0 511 585 B1**
(45) Veröffentlichungstag und Bekanntmachung des Hinweises auf die Patenterteilung: **07.12.1994**
(21) Anmeldenummer: 92106911.8
(22) Anmeldetag: 23.04.1992
(51) Int. Cl.: G03F 7/32

(54) **Verfahren zur Herstellung einer Reliefdruckform**
Method of prducing a relief printing plate
Procédé de fabrication d'une plaque d'impression en relief

(30) Priorität: 30.04.1991 DE 4114060
(43) Veröffentlichungstag der Anmeldung: 04.11.1992
(73) Patentinhaber: E.I. DU PONT DE NEMOURS AND COMPANY, Wilmington Delaware 19898 (US)
(72) Erfinder: Schlosser, Hans-Joachim, Dr., W-6200 Wiesbaden (DE)
(74) Vertreter: Pistor, Wolfgang, Dipl.-Chem.

(56) Entgegenhaltungen:
- EP-A- 0 332 070
- WO-A-90/11550

## Beschreibung

Die Erfindung betrifft ein Verfahren zur Herstellung einer Reliefdruckform, worin ein Aufzeichnungsmaterial, das aus einem Träger und einer negativ arbeitenden, strahlungsempfindlichen Schicht besteht, die als wesentliche Bestandteile ein elastomeres Polymer, ein damit verträgliches photopolymerisierbares Monomer und einen Photoinitiator enthält, a)mit aktinischer Strahlung bildmäßig bestrahlt und b) mit einem Lösemittel entwickelt wird.

Bei der Herstellung von Reliefformen besteht die Aufgabe des Lösemittels darin, die nicht vernetzten Anteile der Schicht möglichst schnell und rückstandsfrei zu lösen. Damit die Reliefform schnell druckfertig ist, muß das Lösemittel zudem von den vernetzten Schichtbereichen leicht wieder entfernbar sein.

In den kommerziell erhältlichen Flexodruckplatten kommen verschiedene elastomere Polymere vor. Für ein universell anwendbares Entwicklungslösemittel ist es daher wichtig, daß damit die verschiedenen am Markt befindlichen Druckplatten unterschiedlicher Zusammensetzung gleich gut entwickelt werden können.

Ein solches Lösemittel zur Entwicklung von negativ arbeitenden strahlungsempfindlichen Schichten mit verschiedenartigem Polymeranteil steht bisher nicht zur Verfügung. Zudem weisen die bisher gebräuchlichen Lösemittel häufig einen unangenehmen Geruch auf und/oder sind aus toxikologischer Sicht bedenklich.

Bisher sind insbesondere Lösemittel mit einem niedrigen Siedepunkt, wie Benzol, Toluol, Xylol, 1,1,1-Trichlorethan, 1,1,2,2-Tetrachlorethan oder Butanon sowie Gemische davon, eingesetzt worden (s. DE-C 22 15 090 = GB-A 1 366 769). In der Praxis verwendet wurde auch eine Mischung aus Tetrachlorethylen und Butanol. Die halogenierten Kohlenwasserstoffe sind jedoch aus toxikologischer Sicht sehr bedenklich. Außerdem bestehen große Probleme bei der Entsorgung der gebrauchten Lösemittel. Für Tetrachlorethylen schreibt die amtliche deutsche "Technische Anleitung Luft (TA Luft)" einen Höchstwert in der Abluft von nur 0,1 kg/h vor. Perchlorethylen gehört auch zur Gruppe der Stoffe, die in dem begründeten Verdacht stehen, krebserregend zu wirken (s. Liste der Maximalen Arbeitsplatz-Konzentrationen (MAK) 1990). Dies steht seiner weiteren Verwendung eindeutig entgegen. Besonders die chlorierten Kohlenwasserstoffe lassen auch die belichteten Bereiche der Schicht stark quellen und können daher nur durch langes Trocknen wieder von den Platten entfernt werden. Die nicht chlorierten Kohlenwasserstoffe, wie Benzol, Toluol und Xylol, führen gleichfalls zu einer starken Quellung der Schicht, sind darüber hinaus jedoch auch noch leicht entzündlich. Wegen ihres niedrigen Flammpunktes können solche Lösemittel nur in explosionsgeschützten Entwicklungsgeräten eingesetzt werden.

In der EP-A 0 365 988 werden Gemische weniger leicht entzündlicher höhersiedender Aromaten beschrieben.

Sie zeigen ein gutes Entwicklungsverhalten. Störend ist jedoch der intensive aromatische Geruch.

Einen noch intensiveren Geruch besitzen auch die in den Beispielen der DE-A 36 00 116 (= US-A 4 806 452) angegebenen Lösemittel auf der Basis von Limonen. Limonen ist jedoch empfindlich gegen Luftsauerstoff und wirkt hautreizend.

Einen störenden Geruch, der selbst den getrockneten Druckplatten noch lange anhaftet, besitzen auch die in der WO 90/02359 beschriebenen Carbonsäureester. Zudem weisen sie einen niedrigen täglichen Arbeitsplatzgrenzwert (OEL, Occupational Exposure Limit) von 50 ppm auf (Performance Fluids, Exxon Chemical, s.a.: Ein praktischer Leitfaden zum Schutz des Menschen und seiner Umwelt, Exxon Chemical 1990, S. 79 - 83).

Ein Verfahren zur Entwicklung einer negativ arbeitenden Photoresistschicht, die kondensiertes Polyisopren als Bindemittel und 2,6-Bis-(4-azido-benzyliden)-4-methyl-cyclohexan als Photoinitiator enthält, ist in der US-A 3 887 373 offenbart. Als Entwickler werden dabei gesättigte Erdölfraktionen, die überwiegend aus Mischungen von gesättigten aliphatischen Kohlenwasserstoffen mit cycloaliphatischen Kohlenwasserstoffen, insbesondere Cyclohexan, bestehen, eingesetzt.

In der WO 90/13853 ist ein Verfahren zur Herstellung von durch Photopolymerisation vernetzten Reliefformen beschrieben. Als Entwicklerlösemittel zum Auswaschen der nach dem bildmäßigen Belichten unvernetzt gebliebenen Anteile der Schicht werden hydrierte Erdölfraktionen oder Gemische aus hydrierten Erdölfraktionen und Alkoholen verwendet. Die hydrierten Erdölfraktionen weisen bevorzugt einen naphthenischen Anteil, d.h. einen Anteil an cyclischen Kohlenwasserstoffen, von 0,5 bis 50 % auf. Die konkret beschriebenen Lösemittel haben einen naphthenischen Anteil von 30 bzw. 35 %. Mit diesen Lösemitteln werden Ein- und Mehrschichtenplatten, die einen 3-Blockkautschuk aus Styrol/Isopren/Styrol-Butadien gemäß EP-A 0 027 612 (= US-A 4 320 188) enthalten, entwickelt. Es wurde jedoch gefunden, daß Flexodruckplatten, die als Bindemittel ein Styrol/Isopren/Styrol-Blockcopolymer gemäß der DE-A 22 15 090 enthalten, bei Verwendung dieser Lösemittel eine wesentlich längere Entwicklungszeit benötigen. Abhängig von Blockgröße und Molekulargewicht des Polymeren beträgt die Entwicklungsdauer bis zum Doppelten derer, die für die Entwicklung von Flexodruckplatten auf der Basis der vorgenannten Blockcopolymeren gemäß der DE-A 22 15 090 benötigt wird. Die in der WO 90/13853 angegebenen Entwicklungslösemittel sind somit nicht universell einsetzbar.

Ein Verfahren zur Entwicklung flexographischer Druckplatten mit Hilfe einer Öl-in-Wasser- bzw. Wasser-in-Öl-Emulsion ist in der DE-A 39 08 763 offenbart. Als organische Phase oder Bestandteil der organischen Phase können neben einer Vielzahl anderer Lösemittel auch hydrierte Erdölfraktionen und Dekalin dienen. Die Emulsion kann weiterhin Alkohole, wie Pentanol oder Hexanol, enthalten. Das Entwicklungsverfahren ist abgestimmt auf ein spezielles flexographisches Aufzeichnungsmaterial, bei dem die optisch transparente Deckschicht und die auszuwaschenden unbelichteten Bereiche der reliefbildenden Aufzeichnungsschicht sich in ihrer Löslichkeit unterscheiden. Entweder ist die Deckschicht in organischen Lösemitteln löslich, zumindest quellbar, und die nicht bestrahlten Bereiche der reliefbildenden Schicht sind in Wasser bzw. wäßrigen Lösemitteln löslich, zumindest jedoch quellbar, oder umgekehrt. Das Verfahren ist folglich in keiner Weise allgemein anwendbar.

Es bestand daher die Aufgabe, ein Entwicklungslöse-mittel für photopolymerschichten zu entwickeln, das nicht toxisch ist, einen ausreichend hohen Flammpunkt besitzt, die vernetzten Anteile der Schicht möglichst wenig quellen läßt und damit von der entwickelten Platte schnell wieder entfernt werden kann, eine möglichst geringe Geruchsbelästigung mit sich bringt und eine annähernd gleiche, möglichst hohe Entwicklungsgeschwindigkeit für möglichst viele der in der Praxis verbreiteten Plattentypen erreicht.

Gelöst wird die Aufgabe durch ein Verfahren zur Herstellung einer Reliefdruckform, worin ein Aufzeichnungsmaterial, das aus einem Träger und einer negativ arbeitenden strahlungsempfindlichen Schicht besteht, die als wesentliche Bestandteile ein elastomeres Polymer, ein damit verträgliches photopolymerisierbares Monomer und einen Photoinitiator enthält, a) mit aktinischer Strahlung bildmäßig bestrahlt und b) mit einem Lösemittel entwickelt wird, dadurch gekennzeichnet, daß als Lösemittel ein Gemisch verwendet wird, das als wesentliche Bestandteile
a) mindestens einen vollständig hydrierten Aromaten mit einem Flammpunkt von über 40°C und einem Siedepunkt im Bereich von 150 bis 220°C und
b) mindestens einen aliphatischen Alkohol mit 4 bis 9 Kohlenstoffatomen

enthält.

Der Anteil des bzw. der vollständig hydrierten Aromaten beträgt im allgemeinen 60 bis 95 Gew.-%, vorzugsweise 65 bis 90 Gew.-%, und der des aliphatischen Alkohols bzw. der aliphatischen Alkohole 5 bis 40 Gew.-%, vorzugsweise 10 bis 35 Gew.-%, jeweils bezogen auf das Gesamtgewicht des Lösemittelgemisches.

Für das Gemisch geeignete hydrierte Aromaten sind beispielsweise Decahydronaphthalin und ein Gemisch aus hydrierten Aromaten, das unter der Bezeichnung ^{(R)}Nappar 10 und ^{(R)}Nappar 11 (Exxon) im Handel erhältlich ist. Ein Gemisch von hydrierten Aromaten ist allgemein bevorzugt. ^{(R)}Nappar 11 darf gemäß der TA-Luft in der Abluft in einer Menge von bis zu 3 kg pro Stunde enthalten sein. Der dafür angegebene OEL-Wert beträgt 300 ppm (Exxon-Sicherheitsdatenblatt, Nov. 1990).

Besonders geeignete (C₄-C₉)Alkanole sind Butanol, Pentanol, 2-Ethyl-butanol und 5-Methyl-hexanol.

Gegebenenfalls können dem Entwicklungslösemittel oberflächenaktive Substanzen, wie ethoxylierte Fettalkohole und Alkansulfonate, zur Erhöhung der Entwicklungsgeschwindigkeit zugesetzt sein.

Mit dem Gemisch lassen sich überraschenderweise nahezu alle handelsüblichen Flexodruckplatten in etwa gleich kurzer Zeit entwickeln. Die Reliefausbildung ist gut und die Trocknungszeit kurz.

Die handelsüblichen Flexodruckplatten sind im allgemeinen mehrschichtig aufgebaut. über einer etwa 0,7 bis 6,7 mm starken reliefbildenden Schicht liegt eine dünne, etwa 5 µm starke Polyamiddeckschicht. Sie verhindert ein Ankleben der Filmvorlage an der Oberfläche der Platte während der Belichtung. Um ein druckfähiges Klischee zu erhalten, muß auch diese Schicht gelöst werden. Dies wird durch den Zusatz der Alkohole erleichtert.

Die folgenden Beispiele und Vergleichsbeispiele dienen zur Veranschaulichung der Erfindung. Sie sollen in keiner Weise die Erfindung beschränken.

Folgende Plattentypen wurden eingesetzt
Plattentyp 1
   wurde hergestellt mit einer strahlungsempfindlichen Schicht bestehend aus
   - 86,7 Gew.-%: 3-Blockkautschuk aus Styrol/Isopren/ Styrol gemäß DE-A 22 15 090 (15% Styrol)
   - 5,0 Gew.-%: Paraffinöl
   - 3,5 Gew.-%: Hexandioldiacrylat
   - 2,5 Gew.-%: Hexandioldimethacrylat
   - 1,5 Gew.-%: Benzildimethylketal
   - 0,8 Gew.-%: 2,6-Di-tert.-butyl-4-methyl-phenol
   - 0,01 Gew.-%: Solvent Black (Colour Index No. 26 150)
   in einer Schichtstärke von 2715 µm auf einer 125 µm starken Polyesterfolie als Trägermaterial und einer 4 µm starken Deckschicht aus Polyamid.
   Die Platte wurde zunächst von der Rückseite her unter Verwendung eines handelsüblichen Röhrenbelichters 90 s lang vollflächig belichtet und dann durch eine aufgelegte Negativvorlage hindurch 14 min lang von der Vorderseite her belichtet.
Plattentyp 2
   Eine handelsübliche Flexodruckplatte mit Kautschuk-Bindemittel gemäß EP-A 0 027 612 (^{(R)}Nyloflex FAR) wurde zunächst von der Rückseite her mit einem handelsüblichen Röhrenbelichter 72 s lang vollflächig belichtet und anschließend durch eine aufgelegte Negativvorlage hindurch 14 min lang von der Vorderseite her belichtet.
Plattentyp 3
   Eine handelsübliche Flexodruckplatte mit Kautschuk-Bindemittel gemäß der DE-A 22 15 090 (^{(R)}Cyrel HLS) wurde zunächst von der Rückseite her mit einem handelsüblichen Röhrenbelichter 75 s lang vollflächig belichtet und anschließend durch eine aufgelegte Negativvorlage hindurch 17 min lang von der Vorderseite her belichtet.
Plattentyp 4
   Eine handelsübliche Flexodruckplatte mit Kautschuk-Bindemittel gemäß DE-A 22 15 090 (^{(R)}Cyrel HOS) wurde zunächst von der Rückseite her mit einem handelsüblichen Röhrenbelichter 70 s lang vollflächig belichtet und anschließend durch eine aufgelegte Negativvorlage hindurch 14 min lang von der Vorderseite her belichtet. Der Plattentyp 4 weist eine höhere Shore-A-Härte auf als der Plattentyp 3.

Entwickelt wurden die Platten nach zwei verschiedenen Varianten:
Variante 1:
   Verwendet wurde eine handelsüblicher Auswascher.Die Flexodruckplatten wurden auf eine an einem Exzenter aufgehängte Metallplatte geklebt und gegen eine Auswaschbürste gedrückt. Die Platte wurde mit wechselnder Drehrichtung (Exzentrizität 2 cm) jeweils viermal in 10 s horizontal gegen die feststehende Bürste bewegt.
Variante 2:
   Verwendet wurde ein handelsübliches Durchlauf-Auswaschgerät für Flexodruckplatten. Die Platten wurden zunächst mit vier oszillierenden Bürsten entschichtet, dann in einer Spülzone gespült und anschließend oberflächlich abgetrocknet.

Beispiel 1
   Eine Flexodruckplatte vom Typ 1 wurde auf die beschriebene Weise belichtet und anschließend nach Variante 1 entwickelt. Als Entwickler diente ein Gemisch aus 80 Gew.-% Decahydronaphthalin und 20 Gew.-% 5-Methyl-hexanol. Nach einer Entwicklungszeit von 6,5 min bei Raumtemperatur war eine Relieftiefe von 1 mm erreicht.
Beispiel 2
   Es wurde eine Flexodruckplatte vom Typ 2 verwendet. Entwickelt wurde die Platte wie im Beispiel 1 angegeben. Die Auswaschzeit für 1 mm Relieftiefe betrug 7 min.
Beispiel 3
   Verwendet wurde eine Flexodruckplatte vom Typ 1. Als Entwicklungslösemittel diente ein Gemisch aus 85 Gew.-% einer hydrierten Aromatenfraktion (^{(R)}Nappar 11, Exxon, mit einem Siedebereich von 196 bis 223°C nach ASTM D-86-82, einem Aromatengehalt unter 2 %, einem Flammpunkt von 68°C und einem Gehalt an hydrierten Aromaten von über 90 %) und 15 Gew.-% 2-Ethyl-butanol. Entwickelt wurde nach Variante 1.
   Die Auswaschzeit für 1 mm Relieftiefe betrug 7,5 min. Die Druckform wurde anschließend 2 h lang bei 65°C getrocknet, dann 15 h lang bei Raumtemperatur gelagert, mit einer wäßrigen Bromlösung nachbehandelt und erneut getrocknet. Die fertige Druckform besaß eine einwandfreie Oberfläche und hatte keinen Geruch.
Beispiel 4
   Es wurde eine Flexodruckplatte vom Typ 2 verwendet. Entwickelt wurde nach Variante 1 mit dem Entwicklungslösemittel aus Beispiel 3. Die Auswaschzeit für 1 mm Relieftiefe betrug 7,5 min.
Beispiel 5
   Es wurde eine Flexodruckplatte vom Typ 1 verwendet. Entwickelt wurde nach Variante 1 mit einem Entwicklungslösemittel aus 75 Gew.-% hydrierter Aromatenfraktion (^{(R)}Nappar 11) und 25 Gew.-% 2-Ethyl-butanol. Die Auswaschzeit für 1 mm Relieftiefe betrug 6,5 min.
Beispiel 6
   Es wurde eine Flexodruckplatte vom Typ 2 verwendet. Entwickelt wurde nach Variante 1 mit dem Entwicklungslösemittel aus Beispiel 5. Die Auswaschzeit für 1 mm Relieftiefe betrug 6,3 min.
Beispiel 7
   Es wurde eine Flexodruckplatte vom Typ 1 verwendet. Entwickelt wurde nach Variante 1 mit einem Entwicklungslösemittel aus 80 Gew.-% hydrierter Aromatenfraktion (^{(R)}Nappar 11) und 20 Gew.-% 5-Methyl-hexanol. Die Auswaschzeit für 1 mm Relieftiefe betrug 6,5 min.
Beispiel 8
   Es wurde eine Flexodruckplatte vom Typ 2 verwendet. Entwickelt wurde nach Variante 1 mit dem Entwicklungslösemittel aus Beispiel 7. Die Auswaschzeit für 1 mm Relieftiefe betrug 6,5 min. Die entwickelte Druckform wurde anschließend 2 h lang bei 65°C getrocknet, dann 15 h lang bei Raumtemperatur gelagert, mit einer wäßrigen Bromlösung nachbehandelt und erneut getrocknet. Die fertige Druckform besaß eine einwandfreie Oberfläche und war geruchlos.
Beispiel 9
   Verwendet wurde eine Flexodruckplatte vom Typ 1. Entwickelt wurde nach Variante 2 mit einem Entwicklungslösemittel aus 85 Gew.-% einer hydrierten Aromatenfraktion (^{(R)}Nappar 11) und 15 Gew.-% 5-Methyl-hexanol. Die gesamte Durchlaufzeit zur Herstellung der oberflächlich getrockneten Platte betrug 12,4 min.
   Die Flexodruckform wurde 2 h lang bei 65°C getrocknet, dann und 15 h lang bei Raumtemperatur gelagert, mit einer wäßrigen Bromlösung nachbehandelt und erneut getrocknet. Die fertige Druckform besaß eine einwandfreie Oberfläche und war geruchlos.
Beispiel 10
   Es wurde eine Flexodruckplatte vom Typ 2 benutzt. Entwickelt wurde nach Variante 2 mit dem Entwicklungslösemittel aus Beispiel 9. Die gesamte Durchlaufzeit zur Herstellung der oberflächlich getrockneten Platte betrug 11,5 min.
   Die Flexodruckform wurde 2h bei 65°C getrocknet und 15 Stunden bei Raumtemperatur gelagert, einer üblichen Nachbehandlung mit wäßriger Bromlösung unterzogen und erneut getrocknet. Die fertige Druckform besaß eine einwandfreie Oberfläche und war geruchlos.
Beispiel 11
   Es wurde eine Flexodruckplatte vom Typ 3 verwendet. Entwickelt wurde nach Variante 2 mit dem Entwicklungslösemittel aus Beispiel 9. Die gesamte Durchlaufzeit zur Herstellung der oberflächlich getrockneten Platte betrug 13,5 min.
   Die Flexodruckform wurde 2 h lang bei 65°C getrocknet, dann 15 h lang bei Raumtemperatur gelagert, mit einer wäßrigen Bromlösung nachbehandelt und erneut getrocknet. Die fertige Druckform besaß eine einwandfreie Oberfläche und war geruchlos.
Beispiel 12
   Es wurde eine Flexodruckplatte vom Typ 4 verwendet. Entwickelt wurde nach Variante 2 mit dem Entwicklungslösemittel aus Beispiel 9. Die gesamte Durchlaufzeit zur Herstellung der oberflächlich getrockneten Platte betrug 11 min.
   Die Flexodruckform wurde 2 h lang bei 65°C getrocknet, dann 15 h lang bei Raumtemperatur gelagert, mit einer wäßrigen Bromlösung nachbehandelt und erneut getrocknet. Die fertige Druckform besaß eine einwandfreie Oberfläche und war geruchlos.

Vergleichsbeispiel 1
   Es wurde wie in Beispiel 1 vorgegangen. Als Entwicklungslösemittel wurde ein Gemisch aus einer hydrierten Erdölfraktion (^{(R)}Exsol D 60, Exxon, mit einem Siedebereich von 181 bis 216°C nach EP-A 0 332 070) und 15 Gew.-% 2-Ethylbutanol benutzt. Die Auswaschzeit betrug 17 min.
Vergleichsbeispiel 2
   Es wurde wie in Vergleichsbeispiel 1 vorgegangen. Als Druckplatte wurde Typ 2 benutzt. Die Auswaschzeit betrug 9 min.
Vergleichsbeispiel 3
   Es wurde wie in Vergleichsbeispiel 1 vorgegangen. Als Auswaschlösemittel wurde ein handelsübliches Entwicklungslösemittel nach EP-A 0 332 070 (^{(R)}Nylosolv) benutzt. Die Auswaschzeit betrug 15 min.
Vergleichsbeispiel 4
   Es wurde wie in Vergleichsbeispiel 3 vorgegangen. Als Druckplatte wurde Typ 2 benutzt. Die Auswaschzeit betrug 7 min.
Vergleichsbeispiel 5
   Es wurde wie in Beispiel 9 vorgegangen. Als Auswaschlösemittel wurde das aus Vergleichsbeispiel 3 benutzt. Die Entwicklung wurde nach Herstellerangabe bei einer Temperatur von 30°C durchgeführt, um die Auswaschgeschwindigkeit zu erhöhen. Die Durchlaufzeit zur Erreichung einer Relieftiefe von 1 mm durch das Gerät betrug 26 min.
Vergleichsbeispiel 6
   Es wurde wie in Vergleichsbeispiel 5 vorgegangen. Als Druckplatte wurde Typ 2 benutzt. Die Durchlaufzeit zur Erreichung einer Relieftiefe von 1 mm betrug 11 min.
Vergleichsbeispiel 7
   Es wurde wie in Vergleichsbeispiel 5 vorgegangen. Als Druckplatte wurde Typ 3 benutzt. Die Durchlaufzeit zu einer Erreichung einer Relieftiefe von 1 mm betrug 22 min.
Vergleichsbeispiel 8
   Es wurde wie in Vergleichsbeispiel 5 vorgegangen. Als Druckplatte wurde Typ 4 benutzt. Die Durchlaufzeit zur Erreichung einer Relieftiefe von 1 mm betrug 15 min.

## Patentansprüche

1. Verfahren zur Herstellung einer Reliefdruckform, worin ein Aufzeichnungsmaterial, das aus einem Träger und einer negativ arbeitenden strahlungsempfindlichen Schicht besteht, die als wesentliche Bestandteile ein elastomeres Polymer, ein damit verträgliches photopolymerisierbares Monomer und einen Photoinitiator enthält, a) mit aktinischer Strahlung bildmäßig bestrahlt und b) mit einem Lösemittel entwickelt wird, dadurch gekennzeichnet, daß als Lösemittel ein Gemisch verwendet wird, das als wesentliche Bestandteile
a) mindestens einen vollständig hydrierten Aromaten mit einem Flammpunkt von über 40°C und einem Siedepunkt im Bereich von 150 bis 220°C und
b) mindestens einen aliphatischen Alkohol mit 4 bis 9 Kohlenstoffatomen
enthält.

2. Verfahren gemäß Anspruch 1, dadurch gekennzeichnet, daß der Anteil des bzw. der vollständig hydrierten Aromaten 60 bis 95 Gew.-%, bevorzugt 65 bis 90 Gew.-%, und der des aliphatischen Alkohols bzw. der aliphatischen Alkohole 5 bis 40 Gew.-%, bevorzugt 10 bis 35 Gew.-%, jeweils bezogen auf das Gesamtgewicht des Lösemittelgemisches, beträgt.

3. Verfahren gemäß Anspruch 1 oder 2, dadurch gekennzeichnet, daß das Lösemittelgemisch zusätzlich oberflächenaktive Substanzen enthält.

## Claims

1. A method for preparing a relief printing form by
a) irradiating imagewise with actinic radiation, and
b) developing with a solvent
a recording material consisting of a support and a negative working radiation sensitive layer which contains as essential components an elastomer, a photopolymerizable monomer compatible therewith, and a photoinitiator,
characterized in that
a mixture containing as essential components
a) at least one aromatic hydrocarbon which is completely hydrogenated and has a flash point above 40 °C and a boiling point in the range of 150 to 220 °C, and
b) at least one aliphatic alcohol having 4 to 9 carbon atoms,
is used as solvent.

2. A method according to claim 1,
characterized in that
the fraction of the completely hydrogenated aromatic hydrocarbon or hydrocarbons is 60 to 95 percent by weight, preferentially 65 to 90 percent by weight, and that of the aliphatic alcohol or alcohols is 5 to 40 percent by weight, preferentially 10 to 35 percent by weight, in each case related to the total weight of the solvent mixture.

3. A method according to claim 1 or 2,
characterized in that
the solvent mixture contains in addition surface active compounds.

## Revendications

1. Un procédé de fabrication d'une plaque d'impression en relief dans lequel un matériau graphique constitué d'un support et d'une couche, sensible au rayonnement et fonctionnant en négatif, qui contient comme constituant essentiel un polymère élastomère, un monomère photopolymérisable compatible avec celui-ci et un photo-initiateur, est
a) irradié par une radiation actinique, conformément au mode d'obtention d'une image; et
b) développé à l'aide d'un solvant;
caractérisé en ce que, l'on emploie comme solvant un mélange qui contient comme constituant essentiel:
a) au moins un aromatique totalement hydrogéné présentant un point d'inflammation supérieur à 40°C et un point d'ébullition dans l'intervalle de 150 à 220°C; et
b) au moins un alcool aliphatique renfermant de 4 à 9 atomes de carbone.

2. Procédé selon la revendication 1, caractérisé en ce que, la proportion du ou des aromatiques totalement hydrogénés atteint de 60 à 95% en poids, de préférence 65 à 90% en poids, et celle de l'alcool aliphatique et/ou des alcools aliphatiques, atteint de 5 à 40% en poids, de préférence 10 à 35% en poids rapportés chaque fois au poids total du mélange de solvant.

3. Procédé selon la revendication 1 ou 2, caractérisé en ce que le mélange de solvant contient en outre des substances tensio-actives.
